(19) Europäisches Patentamt
European Patent Office
Office européen des brevets

(11) Publication number: **0 045 610**
**B1**

(12) **EUROPEAN PATENT SPECIFICATION**

(45) Date of publication of patent specification: **27.01.88**

(51) Int. Cl.⁴: **G 11 C 17/00**

(21) Application number: **81303429.5**

(22) Date of filing: **27.07.81**

(54) **A semiconductor read only memory device.**

(30) Priority: **31.07.80 JP 105882/80**

(43) Date of publication of application:
**10.02.82 Bulletin 82/06**

(45) Publication of the grant of the patent:
**27.01.88 Bulletin 88/04**

(84) Designated Contracting States:
**DE FR GB**

(56) References cited:
**US-A-3 765 002**
**US-A-4 082 966**
**US-A-4 185 321**

(73) Proprietor: **FUJITSU LIMITED**
**1015, Kamikodanaka Nakahara-ku**
**Kawasaki-shi Kanagawa 211 (JP)**

(72) Inventor: **Murakami, Jyoji**
**236-1-410, Suwa Takatsu-ku**
**Kawasaki-shi Kanagawa 213 (JP)**

(74) Representative: **Sunderland, James Harry et al**
**HASELTINE LAKE & CO Hazlitt House 28**
**Southampton Buildings Chancery Lane**
**London WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

**EP 0 045 610 B1**

Courier Press, Leamington Spa, England.

**Description**

This invention relates to a semiconductor memory device, especially to a semiconductor mask read only memory device with a high speed read cycle.

Generally, there are two types of read only memory (ROM) which may be used for the storage device of a digital computer, one is a programmable read only memory (PROM) which can be programmed when it is used, the other is a mask ROM which is programmed during the manufacturing process.

In recent years, in accordance with the miniaturizing and the speed up of the computer, it is required to integrate a mask ROM used for storing a computer program etc. on a larger scale and to speed up its read out time.

In Fig. 1, a semiconductor mask ROM is illustrated. The mask ROM of Fig. 1 comprises a load transistor of a depletion type $Q_L$, a multiplexer MPX consisting of a plurality of transistors $Q_{x0}$, $Q_{x1}$...$Q_{xn}$ to the gates of which the address selecting signals $A_0$, $A_1$...$A_n$ are respectively applied, a memory cell array having transistors $Q_{ij}$ (i=0, 1...m, j=0, 1...n) with gates connected to the word lines $WL_0$, $WL_1$...$WL_m$, and a gate transistor $Q_G$ inserted between the load transistor $Q_L$ and the multiplexer MPX. The ROM of Fig. 1 is not part of the prior art. The circuit of Fig. 1 is a development of a prior art circuit (e.g. US—A—3765002) which, in particular, lacks the gate transistor $Q_G$ of Fig. 1.

As shown in Fig. 1, the gate of the gate transistor $Q_G$ is supplied with the output signal of a voltage control circuit CNT. In the voltage control circuit CNT, a depletion type transistor $Q_{c1}$ and transistors $Q_{c2}$ and $Q_{c3}$ are connected in series between the voltage source $V_{cc}$ and the ground. The voltage $V(N_0)$ at the node $N_0$ where the load transistor $Q_L$ and the gate transistor $Q_G$ are connected, is supplied to the data bus line DB through the buffer circuit BUF as shown. In the buffer circuit BUF, there are provided gate circuits $GT_1$, $GT_2$ and transistors $Q_{B1}$, $Q_{B2}$ interconnected as shown in Fig. 1.

The transistors $Q_{x0}$, $Q_{x1}$...$Q_{xn}$ of the multiplexer MPX, are connected to the bit lines $BL_0$, $BL_1$...$BL_n$ respectively, the transistor $Q_{ij}$ (i=0, 1...m, j=0, 1...n) of the memory cell array is corresponding to the word line $WL_i$ and the bit line $BL_j$. The gate of the transistor $Q_{ij}$ is connected to the word line $WL_i$ and its source is connected to the ground. The drain of the transistor $Q_{ij}$ is connected to the bit line $BL_j$ in the case that the data "0" is stored in the memory cell of the transistor $Q_{ij}$, and the drain of the transistor $Q_{ij}$ is disconnected to the bit line $BL_j$ in the case that the data "1" is stored in this memory cell.

The read operation in the ROM of Fig. 1 will be described as follows. The ROM of Fig. 1 has two operation modes, one mode is of the preparation operation for reading and other mode is of the reading operation. In the preparation operation for reading all selecting signals $A_0$, $A_1$...$A_n$ of the multiplexer MPX and all word lines $WL_0$, $WL_1$...$WL_m$ are rendered to the "H" level. Therefore, all transistors $Q_{ij}$ of the memory cell array MCA become conductive and consequently the charge accumulated in the stray capacity of each bit line $BL_0$, $BL_1$...$BL_n$ is discharged through the transistors $Q_{ij}$ connected to the bit line $BL_j$ and the potentials at the bit lines $BL_0$, $BL_1$... $BL_n$ decrease to the ground level. According to the decrease of the potentials at the bit lines $BL_0$, $BL_1$...$BL_n$, the charge accumulated in the stray capacity of the node $N_0$ is discharged through the gate transistor $Q_G$ and the transistors $Q_{x0}$, $Q_{x1}$...$Q_{xn}$ of the multiplexer MPX. Therefore, the potential at the node $N_0$ turns to the "L" level.

Then, in the reading operation, in order to read the data stored in a certain memory cell, one of the selecting signals $A_0$, $A_1$...$A_n$ and one of the word lines $WL_0$, $WL_1$...$WL_m$ are kept at the "H" level, and the other selecting signals and the other word lines are turned to the "L" level. For example, in the case of reading the memory cell of the transistor $Q_{01}$, only the selecting signals $A_1$ and the word line $WL_0$ are kept at the "H" level, and the other selecting signals $A_0$, $A_2$...$A_n$ and the other word lines $WL_1$, $WL_2$...$WL_m$ are turned to the "L" level. In this case, only the transistor $Q_{x1}$ is conductive and all the other transistors $Q_{xj}$ of the multiplexer MPX are non-conductive. Among the transistors $Q_{i1}$ of bit line $BL_1$, only the transistor $Q_{01}$ is conductive and the other transistors $Q_{j1}$ are non-conductive. As the transistor $Q_{01}$ is connected to the bit line $BL_1$, the current suplied from the voltage source $V_{cc}$ flows through transistors $Q_L$, $Q_G$, $Q_{x1}$ and $Q_{01}$ to the ground, and therefore the charge is not accumulated in the stray capacity of the node $N_0$ and the potential at the node $N_0$ is held at the "L" level. Accordingly, the data of "L" level (that is "0") is transmitted to the data bus line DB through the buffer circuit BUF.

Then, in the case of reading the memory cell of the transistor $Q_{11}$, only the selecting signal $A_1$ and the word line $WL_1$ are held to be the "H" level. Accordingly, among the transistors of the multiplexer MPX only $Q_{x1}$ is conductive and among the transistors of the bit line $BL_1$ only $Q_{11}$ is conductive. In this case, the transistor $Q_{11}$ is disconnected to the bit line $BL_1$ so that the bit line $BL_1$ is disconnected to the ground. Therefore, the current supplied from the voltage source $V_{cc}$ is flowing into the stray capacity of the bit line $BL_1$ through transistors $Q_L$, $Q_G$ and $Q_{x1}$, and the capacity is charged by this current. Thus, the potentials at the bit line $BL_1$ and the node $N_0$ rise up and reach to the "H" level. This "H" level signal of the node $N_0$ is transmitted to the data bus DB through the buffer circuit BUF.

However, in the ROM of Fig. 1, together with the increase of the memory capacity and the integration scale of a memory device, the size of the transistor $Q_{ij}$ of the memory cell becomes smaller, so that the resistance of the main current path of the transistor $Q_{ij}$ becomes greater. Since the output signal level of the node $N_0$ in the case of reading "L" level data, is mainly determined by the ratio between the resistors of the memory cell

transistor $Q_{ij}$ and the load transistor $Q_L$, in order to obtain an appropriate output signal level, it is necessary to make the resistance of the load transitor $Q_L$ greater proportionally. However, since in accordance with the increase in the resistance of the main current path of the load transistor $Q_L$, the drive capacity of the load transistor $Q_L$ decreases, it takes a considerably longer time to charge the bit lines having an equivalently large capacity, and to raise the potential to the "H" level. In the prior art circuit lacking $Q_G$ this results in an increase in access time.

In order to prevent an increase in the access time of the memory device according to the above-mentioned decrease of the drive capacity of the load transistor $Q_L$, in accordance with the ROM of Fig. 1 the gate transistor $Q_G$ is provided. The function of the gate transistor $Q_G$ in the above-mentioned reading operation of the memory cell transistor $Q_{11}$ will now be described. As described above, in the reading operation of the transistor $Q_{11}$, the charge accumulated in the stray capacity of the bit line $BL_1$ is supplied from the voltage source $V_{cc}$ through the load transistor $Q_L$, the gate transistor $Q_G$ and the transistor $Q_{x1}$ of the muliplexer MPX. The output signal $V_{INT}$ of the gate voltage control circuit CNT is applied to the gate of the gate transitor $Q_G$, and if the potential at the node $N_1$ connected to the source of the gate transistor $Q_G$ is lower than the level of the signal $V_{INT}$, the resistance of the main current path of the gate transistor $Q_G$ is relatively small, and therefore the potential at the bit line $BL_1$ rises gradually according to the drive capacity of the load transistor $Q_L$. In accordance with this, the potentials at the nodes $N_0$ and $N_1$ also rise, and when the difference between the potentials at the gate of the gate transistor $Q_G$ and at the node $N_1$ is below the threshold voltage $V_{TH}$ of the gate transistor $Q_G$, the gate transistor $Q_G$ is turned into the cut-off state so that the bit line $BL_1$ and the node $N_1$ is separated from the node $N_0$. Therefore, the potential at the node $N_0$ which has been rising gradually in accordance with the potential at the bit line $BL_1$, then rises rapidly and turns to the "H" level.

As described above, in accordance with the ROM of Fig. 1, since the stray capacity of the bit line $BL_j$ is separated from the node $N_0$ by means of the gate transistor $Q_G$, in spite of the small drive capacity of the load transistor $Q_L$, an increase in the access time of the memory cell can be prevented. However, since the gate voltage of the gate transistor $Q_G$ is intermediate between the voltage source $V_{cc}$ and the ground level, the resistance value of the gate transistor $Q_G$ as a resistance element is considerably great. Therefore, in the ROM of Fig. 1, though the reading operation time becomes shorter, there is a problem that it takes a rather long time to decrease the potential at the node $N_0$ to the "L" level in the preparation operation for reading.

The main object of the present invention is to solve the above-mentioned problems of semiconductor read only memory devices and to speed up the read cycle time in the memory device with a larger memory capacity and with integration on a larger scale.

In accordance with the present invention, there is provided a semiconductor read only memory device comprising a plurality of bit lines, a plurality of word lines, a load transistor electrically connected to a voltage source, a multiplexer including a plurality of transistors each of which is electrically connected to one of said plurality of bit lines, and a memory cell array in which each memory cell has one transistor having a gate electrically connected to one of said word lines and a source or a drain region electrically connected to one of said bit lines, characterised by a gate transistor, and a gate voltage control circuit for selectively providing, to the gate of said gate transistor, a higher level signal during a preparation period of said memory device and lower level signal during a reading period of said memory device.

Brief description of the drawing

Fig. 1 illustrates a circuit diagram of a semiconductor read only memory device which is not part of the prior art,

Fig. 2 illustrates a circuit diagram of a semiconductor read only memory device in accordance with the present invention,

Fig. 3 illustrates a circuit diagram of a clock pulse generator supplying the ROM of Fig. 2 with a system clock pulse, and

Figs. 4 (1) through (6) illustrate various waveforms for explaining the read operation of the ROM of Fig. 2.

Description of the preferred embodiments

A semiconductor read only memory device in accordance with the present invention is illustrated in Fig. 2. In the read only memory of Fig. 2, there are provided a load transistor $Q_L$, a multiplexer MPX including a plurality of transistors $Q_{x0}$, $Q_{x1}...Q_{xn}$, a memory cell array MCA consisting of transistors $Q_{ij}$(i=0, 1...m, j=0, 1...n), a gate transistor $Q_G$ inserted between the load transistor $Q_L$ and the multiplexer MPX, a gate voltage control circuit CNT controlling the gate voltage of the gate transistor $Q_G$, and, a buffer circuit BUF transmitting the voltage level at the node $N_0$ between the load transistor $Q_L$ and the gate transistor $Q_G$ to the data bus line DB.

The device shown in Fig. 2 has the same construction as that of the device of Fig. 1 except the gate voltage control circuit CNT. The gate voltage control circuit CNT has a depletion type transistor $Q_{c1}$ and transistors $Q_{c2}$, $Q_{c3}$, $Q_{c4}$ and $Q_{c5}$.

The ROM of Fig. 2 may be supplied with a clock pulse signal P and its inverted signal $\overline{P}$ from a clock pulse generating circuit such as is shown in Fig. 3. In the clock pulse generating circuit of Fig. 3, a waveform generated by a quartz oscillator QAZ and an inverting amplifier $IV_1$ is shaped by a wave-shaping circuit WSP and then the shaped waveform is outputted as a system clock pulse P and its inverted waveform is outputted as $\overline{P}$. In the

wave-shaping circuit, several inverters $IV_2$, $IV_3$...$IV_5$ are connected in series.

In Figs. 4 (1) through (6), there are illustrated various waveforms to explain the access operation of the ROM of Fig. 2. In Figs. 4 (1) and (2), the system clock pulse P and its inverted pulse $\overline{P}$ are illustrated respectively. In the waveform P illustrated in Fig. 4 (1), the period when the level of the waveform is "L" is the preparation period $T_{PREP}$ of the memory device, and the period when the level of the waveform is "H" in the reading period $T_{READ}$ of the memory device. Accordingly, in the ROM of Fig. 2, the read operation is effected in phase with the system clock P.

In the control circuit CNT of Fig. 2, the system clock signal P is applied to the gate of the transistor $Q_{c4}$, and the inverted signal $\overline{P}$ of the system clock is applied to the gate of the transistor $Q_{c5}$. Therefore, in the preparation period $T_{PREP}$, the transistor $Q_{c4}$ of OFF and the transistor $Q_{c5}$ is ON and consequently the gate voltage of the transistor $Q_{c3}$ is the "L" level and the transistor $Q_{c3}$ is OFF. Accordingly, the voltage at the node $N_2$ connected to the gate of the gate transistor $Q_G$ becomes almost equal to the voltage source $V_{cc}$, because the node $N_2$ is connected to $V_{cc}$ through the depletion type transistor $Q_{c1}$ and cut-off from the ground. On the other hand, in the reading period $T_{READ}$, since the transistor $Q_{c4}$ is ON and the transistor $Q_{c5}$ is OFF, and then the transistor $Q_{ce}$ in ON. Accordingly, the current path between the voltage source $V_{cc}$ and the ground is formed through the transistors $Q_{c1}$, $Q_{c2}$ and $Q_{c3}$, and the voltage at the node $N_2$ applied to the gate of the gate transistor $Q_G$ is dropped to the intermediate level $V_{INT}$ which is divided by the depletion type transistor $Q_{c1}$ and other transistors $Q_{c2}$, $Q_{c3}$.

In Figs. 4 (3) through (6), there are illustrated voltage waveforms at various points of the ROM of Fig. 2 in the case that the memory cell transistor $Q_{11}$ is read-out in the first reading period $T_{READ}$ (between $T_1$ and $T_2$) in Fig. 4 (1), and the memory cell transistor $Q_{01}$ is read-out in the second reading period $T_{READ}$ (between $T_3$ and $T_4$).

As shown in Figs. 4 (3) and (4), in the preparation period $T_{PREP}$, all the selecting signals $A_0$, $A_1$...$A_n$ for the transistors $Q_{x0}$, $Q_{x1}$...$Q_{xn}$ are "H" level and all the word lines $WL_0$, $WL_1$...$WL_m$ are also "H" level. Therefore, the potential $V(N_1)$ at the node $N_1$ and the potential $V(N_0)$ at the node $N_0$ are "L" level. At the instant $T_1$, the system clock signal P rises up to "H" level and then all the selecting signals $A_0$, $A_2$...$A_n$ except $A_1$ turn to the "L" level, and also all the word lines $WL_0$, $WL_2$...$WL_m$ except $WL_1$ turn to the "L" level.

Therefore, all the transistors $Q_{x0}$, $Q_{x2}$...$Q_{xn}$ of the multiplexer MPX except $Q_{x1}$ are turned OFF and only the bit line $BL_1$ is connected to the $N_1$ through the transistor $Q_{x1}$. And also, all the memory cell transistors $Q_{ij}$ except those connected to the word line $WL_1$ (that is, except $Q_{10}$, $Q_{11}$...$Q_{1n}$) are turned OFF. Since the memory cell transistor $Q_{11}$ which corresponds to the bit line $BL_1$ and the word line $WL_1$, is not connected to the bit line $BL_1$, the bit line $BL_1$ is separated from the ground and consequently the potentials at the bit line $BL_1$ and the node $N_1$ begin to rise because of the current supplied through the load transistor $Q_L$ and the gate transistor $Q_G$.

In Figs. 4 (5) and (6), the potentials $V(N_1)$ and $V(N_0)$ at the nodes $N_1$ and $N_2$ are illustrated respectively. As described above, the intermediate level signal VINT is applied to the gate of the gate transistor $Q_G$ in the reading period $T_{READ}$, and the potential $V(N_1)$ is almost the ground level at first so that the potential $V(N_1)$ at the node $N_1$ rises gradually by means of the relatively great resistance of the load transistor $Q_L$. When the potential $V(N_1)$ attains to a level lower than the gate voltage $V_{INT}$ by the threshold voltage $V_{TH}$ of the gate transistor $Q_G$, the gate transistor $Q_G$ turns OFF and after that time the potential $V(N_1)$ does not rise any more. On the other hand, the potential $V(N_0)$ at the node $N_0$ begins to rise up rapidly because the node $N_0$ is separated from the node $N_1$ and the bit line $BL_1$, and the potential $V(N_0)$ attains the "H" level immediately. Thus, the read operation of the "H" level data is made shorter than that in the case where the gate transistor $Q_G$ does not turn off as shown in the broken line of Fig. 4 (6).

Then, at the instant $T_2$, the system clock signal P turns to the "L" level, and then all the selecting signals $A_0$, $A_1$...$A_n$ and all the word lines $WL_0$, $WL_1$...$WL_m$ turn to the "H" level. Consequently, all the transistors $Q_{x0}$, $Q_{x1}$...$Q_{xn}$ of the multiplexer MPX turn ON and all the memory cell transistors $Q_{ij}$ also turn ON. Then, the potentials at the bit line $BL_1$ and the node $N_1$ decrease rapidly to the ground potential. On the other hand, the charge accumulated in the stray capacity of the node $N_0$ is drawn to the node $N_1$ through the gate transistor $Q_G$. As described above, the $V_{cc}$ level signal is applied to the gate of the gate transistor $Q_G$ in the preparation time $T_{PREP}$ so that the gate transistor $Q_G$ is sufficiently conductive and its resistance is substantially small. Therefore, the potential $V(N_0)$ at the node $N_0$ drops to the "L" level in a short time.

Then, at the instant $T_3$, the system clock signal P turns to the "H" level, and all the selecting signals $A_0$, $A_2$...$A_n$ except $A_1$ and all the word lines $WL_1$, $WL_2$...$WL_m$ except $WL_0$ turn to the "L" level. Accordingly, only the transistor $Q_{x1}$ of the multiplexer MPX is kept ON and other transistors $Q_{x0}$, $Q_{x2}$...$Q_{xn}$ turn OFF. Therefore, only the bit line $BL_1$ is connected to the node $N_1$. Since the memory cell transistor $Q_{01}$ is turned ON by the word line $WL_1$ and the transistor $Q_{01}$ is connected to the bit line $BL_1$, the potential at the bit line $BL_1$ is kept at the "L" level, and the potentials at the nodes $N_1$ and $N_0$ are also kept at the "L" level. Thus, the reading operation of the "L" level data is effected almost instantly.

As described above, in accordance with the ROM of Fig. 2, by changing the gate voltage of the gate transistor between the preparation period and the reading period of the memory device, the read operation time can be made shorter.

## Claims

1. A semiconductor read only memory device comprising a plurality of bit lines ($BL_0$ to $BL_n$), a plurality of word lines ($WL_0$ to $WL_m$), a load transistor ($Q_L$) electrically connected to a voltage source ($V_{cc}$), a multiplexer (MPX) including a plurality of transistors ($Q_{x0}$ to $Q_{xn}$) each of which is electrically connected to one of said plurality of bit lines, and a memory cell array (MCA) in which each memory cell has one transistor ($Q_{00}$ to $Q_{mn}$) having a gate electrically connected to one of said word lines and a source or a drain region electrically connected or not connected to one of said bit lines (in dependence upon the information held by the cell), characterised in that, a gate transistor ($Q_G$) is inserted between said load transistor ($Q_L$) and said multiplexer (MPX), and a gate voltage control circuit (CNT) for selectively providing, to the gate of said gate transistor ($Q_G$, a higher level signal during a preparation period of said memory device and a lower level signal during a reading period of said memory device.

2. A device as claimed in claim 1, wherein the gate voltage control circuit (CNT) comprises a first, depletion-type, transistor ($Q_{c1}$), and second ($Q_{c2}$) and third ($Q_{c3}$) transistors, connected in series between the voltage source ($V_{cc}$) and ground, the common connection point ($N_2$) of the first ($Q_{c1}$) and second ($Q_{c2}$) transistors being connected to the gate of the gate transistor ($Q_G$), and fourth ($Q_{c4}$) and fifth ($Q_{c5}$) transistors connected in series between the common connection point of the second ($Q_{c2}$) and third ($Q_{c3}$) transistors and ground, the common connection point of the fourth ($Q_{c4}$) and fifth ($Q_{c5}$) transistors being connected to the gate of the third transistor ($Q_{c3}$) and the gates of the fourth ($Q_{c4}$) and fifth ($Q_{c5}$) transistors being connected respectively to receive mutually inverse clock signals ($P, \overline{P}$) which take different levels, for switching the fourth transistor ($Q_{c2}$) off and on, and the fifth transistor ($Q_{c5}$) on and off, in the preparation period and the reading period.

## Patentansprüche

1. Halbleiterfestwertspeichereinrichtung mit einer Vielzahl von Bitleitungen ($BL_0$ bis $BL_n$), einer Vielzahl von Wortleitungen ($WL_0$ bis $WL_m$), einem Lasttransistor ($Q_L$), der elektrisch mit einer Spannungsquelle ($V_{cc}$) verbunden ist, einem Multiplexer (MPX), der eine Vielzahl von Transistoren ($Q_{x0}$ bis $Q_{xn}$) enthält, von denen jeder elektrisch mit einer der genannten Vielzahl von Bitleitungen verbunden ist, und einer Speicherzellenanordnung (MCA), in der jede Speicherzelle einen Transistor ($Q_{00}$ bis $Q_{mm}$) hat, der ein Gate hat, das elektrisch mit einer der Wortleitungen verbunden ist, und einen Source- oder Drain-Bereich, der elektrisch mit einer der Bitleitungen verbunden ist oder nicht (in Abhängigkeit von der Information, die in der Zelle gehalten wird), dadurch gekennzeichnet, daß ein Gatetransistor ($Q_G$) eingefügt ist zwischen dem genannten Lasttransistor ($Q_L$) und dem genannten Multplexer (MPX) und einer Gatespannungssteuerschaltung (CNT), die an das Gate des genannten Gatetransistors ($Q_G$) wahlweise während einer Vorbereitungsperiode der genannten Speichereinrichtung ein Signal höheren Pegels, und während einer Leseperiode der genannten Speichereinrichtung ein Signal niedrigeren Pegels liefert.

2. Vorrichtung nach Anspruch 1, bei der die Gatespannungssteuerschaltung (CNT) einen ersten Transistor ($Q_{c1}$) vom Verarmungstyp, einen Zweiten ($Q_{c2}$) und einen dritten ($Q_{c3}$) Transistor umfaßt, die in Reihe zwischen der Spannungsquelle ($V_{cc}$) und Masse verbunden sind, wobei der gemeinsame Verbindungspunkt ($N_2$) des ersten ($Q_{c1}$) und zweiten ($Q_{c2}$) Transistors mit dem Gate des Gatetransistors ($Q_G$) verbunden ist, und einen vierten ($Q_{c4}$) und fünften ($Q_{c5}$) Transistor, die in Reihe zwischen einem gemeinsamen Verbindungspunkt des zweiten ($Q_{c2}$) und dritten ($Q_{c3}$) Transistors und Masse verbunden sind, wobei der gemeinsame Verbindungspunkt des vierten ($Q_{c4}$) und fünften ($Q_{c5}$) Transistors mit dem Gate des dritten Transistors ($Q_{c3}$) verbunden ist und die Gates des vierten ($Q_{c4}$) und fünften ($Q_{c5}$) Transistors jeweils angeschlossen sind, um wechselseitig inverse Taktsignale ($P, \overline{P}$) zu empfangen, welche verschiedene Pegel annehmen, um den vierten Transistor ($Q_{c4}$) ausund einzuschalten und den fünften Transistor ($Q_{c4}$) einund auszuschalten, während der Vorbereitungsperiode und der Leseperiode.

## Revendications

1. Dispositif de mémoire morte à semiconducteur comprenant un ensemble de fils de bit ($BL_0$ à $BL_n$), un ensemble de fils de mot ($WL_0$ à $WL_m$), un transistor de charge ($Q_L$) connecté électriquement à une source de tension ($V_{cc}$), un multiplexeur (MPX) incluant un ensemble de transistors ($Q_{x0}$ à $Q_{xn}$) dont chacun est connecté électriquément à un fil de l'ensemble de fils de bit, et une matrice de cellules de mémoire (MCA) dans laquelle chaque cellule de mémoire comporte un transistor ($Q_{00}$ à $Q_{mn}$) ayant une grille connectée électriquement à un des fils de mot et une région de source ou une région de drain connectée électriquement ou non connectée à un des fils de bit (selon l'information maintenue par la cellule), caractérisé en ce qu'un transistor de contrôle ($Q_G$) est inséré entre le transistor de charge ($Q_L$) et le multiplexeur (MPX), et un circuit de réglage de tension de grille (CNT) sert à fournir sélectivement à la grille du transistor de contrôle ($Q_G$) un signal de niveau supérieur pendant une période de préparation du dispositif de mémoire et un signal de niveau inférieur pendant une période de lecture du dispositif de mémoire.

2. Dispositif selon la revendication 1, dans lequel le circuit de réglage de tension de grille (CNT) comprend un premier transistor du type à appauvrissement ($Q_{c1}$), et des deuxième ($Q_{c2}$) et troisième ($Q_{c3}$) transistors, connectés en série entre la source de tension ($V_{cc}$) et la masse, le pointe de connexion commun ($N_2$) des premier ($Q_{c1}$) et deuxième ($Q_{c2}$) transitors étant connecté à la grille du transistor de contrôle ($Q_G$), et des quatrième ($Q_{c4}$) et cinquième ($Q_{c5}$) transistors connectés en série entre le point de connexion commun des deuxième ($Q_{c2}$) et troisième ($Q_{c3}$) transistors et la masse, le point de connexion commun des quatrième ($Q_{c4}$) et cinquième ($Q_{c5}$) transistors étant connecté à la grille du troisième transistor ($Q_{c3}$) et les grilles des quatrième ($Q_{c4}$) et cinquième ($Q_{C5}$) transistors étant connectées respectivement pour recevoir des signaux d'horloge inverses entre eux ($P, \overline{P}$) qui prennent des niveaux différents, pour rendre le quatrième transistor ($Q_{c4}$) bloqué et conducteur, et le cinquième transistor ($Q_{c5}$) conducteur et bloqué, pendant la période de préparation et la période de lecture.

Fig. 1

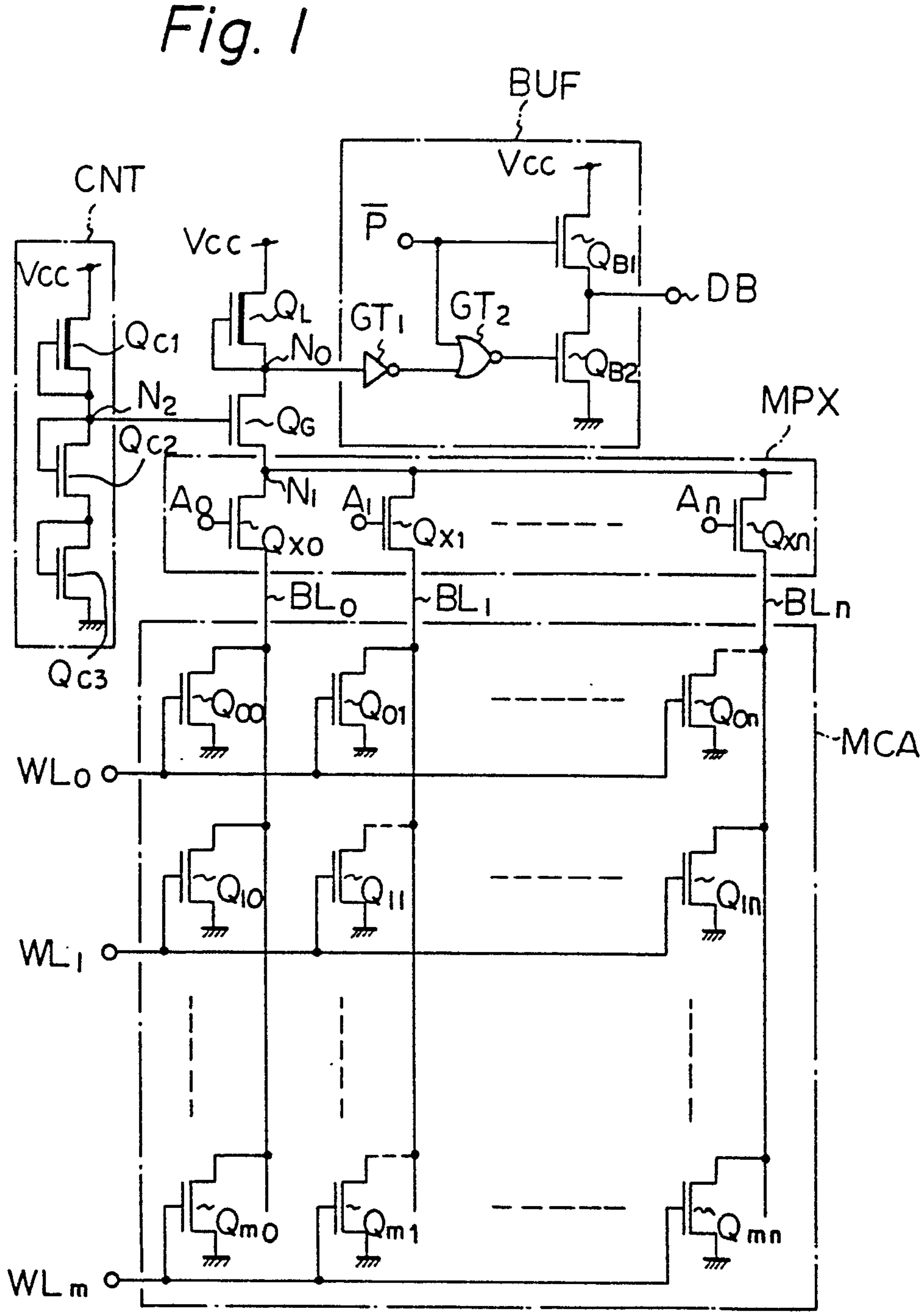
BUF
CNT
Vcc
$\overline{P}$
$Q_{B1}$
DB
$Q_L$
$GT_1$
$GT_2$
$N_0$
$Q_{B2}$
$Q_{C1}$
$N_2$
$Q_G$
MPX
$Q_{C2}$
$N_1$
$A_0$
$A_1$
$A_n$
$Q_{X0}$
$Q_{X1}$
$Q_{Xn}$
$BL_0$
$BL_1$
$BL_n$
$Q_{C3}$
$Q_{00}$
$Q_{01}$
$Q_{0n}$
MCA
$WL_0$
$Q_{10}$
$Q_{11}$
$Q_{1n}$
$WL_1$
$Q_{m0}$
$Q_{m1}$
$Q_{mn}$
$WL_m$

Fig. 2

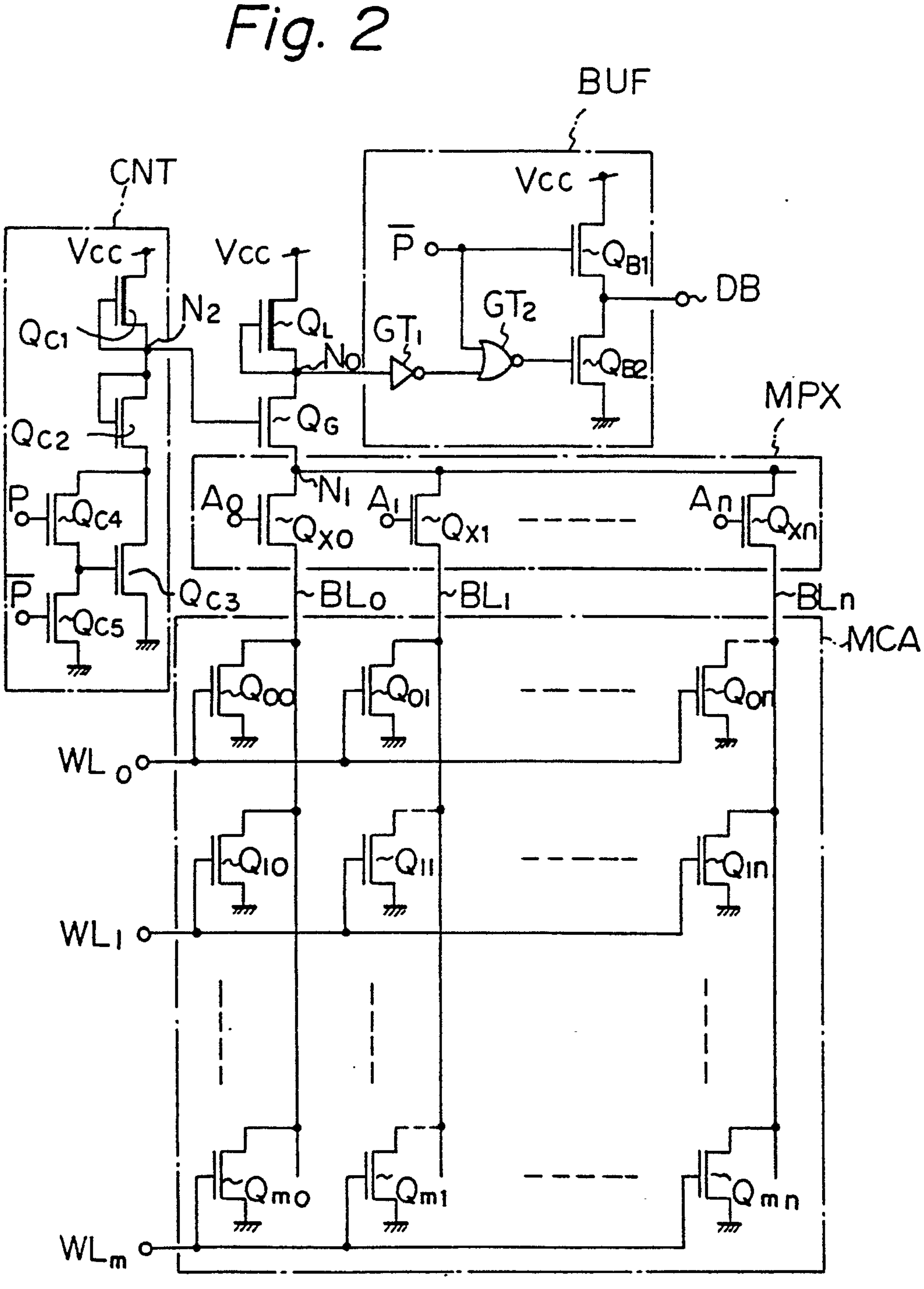
BUF
CNT
Vcc
Vcc
Vcc
P
QB1
DB
QC1
N2
QL
GT1
GT2
N0
QB2
QC2
QG
MPX
P
QC4
A0
N1
A1
QX1
An
QXn
QX0
P
QC3
BL0
BL1
BLn
QC5
MCA
Q00
Q01
Q0n
WL0
Q10
Q11
Q1n
WL1
Qm0
Qm1
Qmn
WLm

Fig. 3

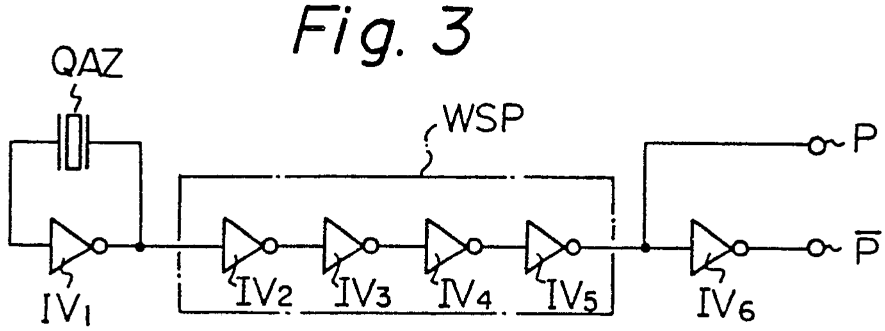
QAZ
WSP
P
$\overline{P}$
IV1
IV2
IV3
IV4
IV5
IV6

Fig. 4

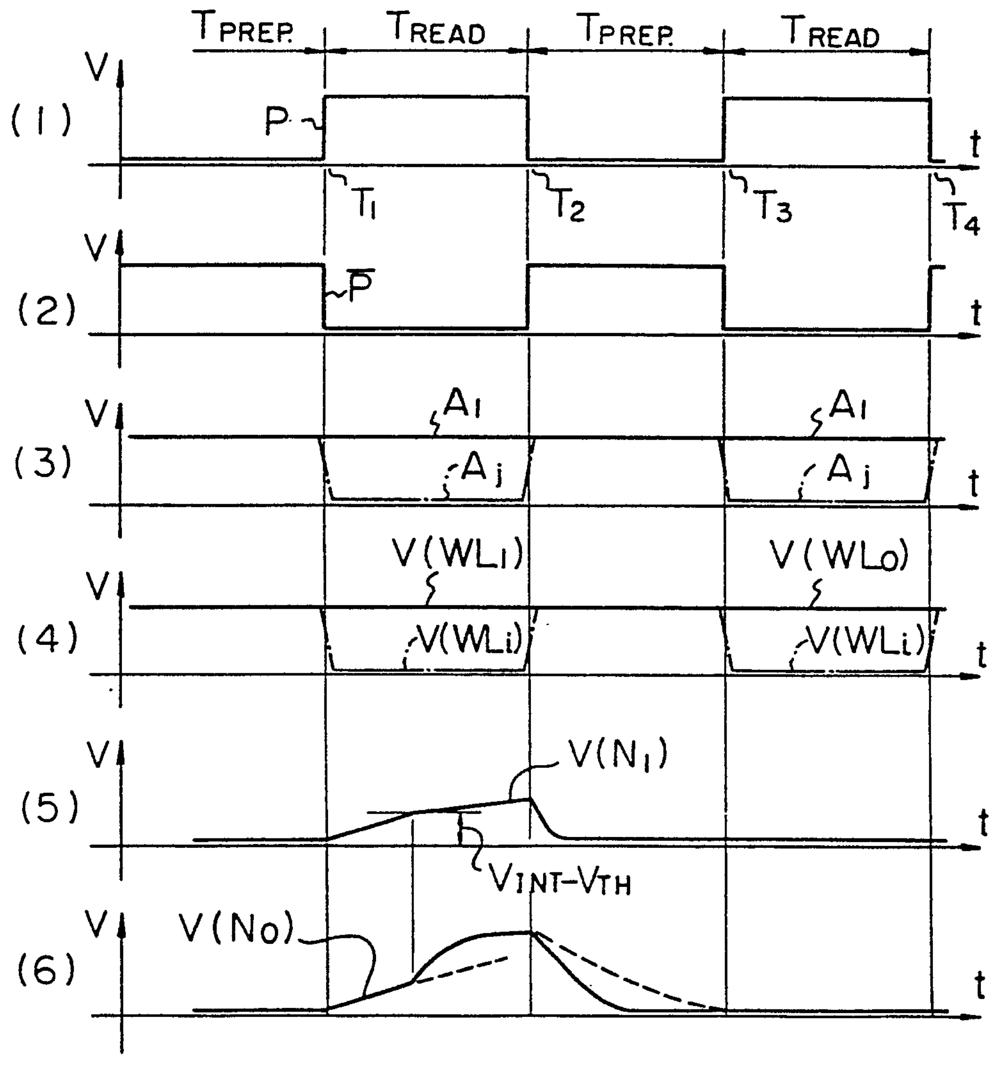
TPREP.
TREAD
TPREP.
TREAD
(1)
(2)
(3)
(4)
(5)
(6)
V
t
P
$\overline{P}$
T1
T2
T3
T4
A1
Aj
V(WL1)
V(WLo)
V(WLi)
V(N1)
VINT-VTH
V(No)